# EUROPEAN PATENT APPLICATION

(11) **EP 4 407 680 A1**
(43) Date of publication of application: **31.07.2024**
(21) Application number: 22929640.5
(22) Date of filing: 13.12.2022
(51) Int. Cl.: H01L 25/07, H01L 23/495, H01L 23/492, H01L 21/60

(54) **CHIP PACKAGING MODULE AND PREPARATION METHOD THEREFOR, POWER SUPPLY MODULE AND ELECTRONIC DEVICE**

(30) Priority: 01.03.2022 CN 202210194673
(71) Applicant: Huawei Digital Power Technologies Co., Ltd., Shenzhen, Guangdong 518043 (CN)
(72) Inventor: HE, Junqing, Shenzhen, Guangdong 518043 (CN); CHANG, Mohuai, Shenzhen, Guangdong 518043 (CN); LI, Yanqiu, Shenzhen, Guangdong 518043 (CN); YANG, Wentao, Shenzhen, Guangdong 518043 (CN)
(74) Representative: Gill Jennings & Every LLP
(86) International application number: PCT/CN2022/138513
(87) International publication number: WO 2023/165213

(57) **Abstract**

This application provides a chip package module, including a first conductive frame, a first bare die disposed on the first conductive frame, and a second conductive frame disposed at an interval beside the first conductive frame. The chip package module further includes a first conductive connecting sheet, a second bare die, and a conductive cover plate. The first conductive connecting sheet is connected to a surface of the first bare die away from the first conductive frame, and extends to be lapped on the second conductive frame. The second bare die is laminated on the first bare die and is connected to the first conductive connecting sheet. The conductive cover plate is connected to a surface of the second bare die away from the first conductive frame and extends to be connected to the first conductive frame. The first conductive connecting sheet and the conductive cover plate are used to implement electrical interconnection between the first bare die and the second bare die that are vertically laminated, and the two bare dies are packaged inside one device, so that performance of a single device is improved. This application further provides a power module including the chip package module, an electronic device, and a method for manufacturing the chip package module.

## Description

### CROSS-REFERENCE TO RELATED APPLICATIONS

This application claims priority to Chinese Patent Application No. 202210194673.X, filed with the China National Intellectual Property Administration on March 1, 2022 and entitled "CHIP PACKAGE MODULE, METHOD FOR MANUFACTURING SAME, POWER MODULE, AND ELECTRONIC DEVICE", which is incorporated herein by reference in its entirety.

### TECHNICAL FIELD

This application relates to the field of chip packaging, and in particular, to a chip package module, a method for manufacturing the chip package module, a power module in which the chip package module is used, and an electronic device.

### BACKGROUND

As power modules such as a power supply in a package (Power Supply In a Package, PSIP) and a brick module power (Brick Module Power, BMP) have increasingly higher requirements on power and application frequency, a single metal-oxide-semiconductor field-effect transistor (Metal-Oxide-Semiconductor Field-Effect Transistor, MOSFET) chip is driven to evolve toward a small size, a low loss, and a high power density. An existing single-transistor MOSFET package includes only one bare wafer. Under a current manufacturing process, a performance improvement speed of wafers gradually cannot match a performance improvement speed of power modules. Only one bare wafer is packaged in a device, and space of a package body in a height direction is not fully used. In addition, performance of a single device fully depends on performance of the bare wafer. When a system requirement is high but performance of the bare wafer is insufficient, a performance bottleneck is formed, hindering further optimization of the power module.

### SUMMARY

A first aspect of embodiments of this application provides a chip package module, including:
a first conductive frame;
a first bare die, disposed on the first conductive frame;
a second conductive frame, disposed at an interval from the first conductive frame;
a first conductive connecting sheet, connected to a surface of the first bare die away from the first conductive frame, and extending to be lapped on the second conductive frame;
a second bare die, laminated on the surface of the first bare die away from the first conductive frame, and connected to the first conductive connecting sheet; and
a conductive cover plate, connected to a surface of the second bare die away from the first conductive frame, and extending to be connected to the first conductive frame.

According to the chip package module in the first aspect of this application, the first conductive connecting sheet, the conductive cover plate, and the like are used to implement electrical interconnection between the first bare die and the second bare die that are vertically laminated, and the two bare dies are packaged inside one device, so that performance of a single device is improved, and a requirement of a high-performance power supply system for a device is met to some extent.

In an implementation of this application, a first electrode of the first bare die is electrically connected to the first conductive frame, and a second electrode of the second bare die is electrically connected to the conductive cover plate, to implement an electrical connection between the first electrode and the second electrode; and both a third electrode of the first bare die and a fourth electrode of the second bare die are electrically connected to the first conductive connecting sheet, to implement an electrical connection between the third electrode and the fourth electrode.

The vertically laminated first bare die and second bare die packaged inside one device have two pairs of electrodes that are electrically interconnected.

In an implementation of this application, the chip package module further includes a third conductive frame and a second conductive connecting sheet, and the first conductive frame, the second conductive frame, and the third conductive frame are disposed at an interval from each other; and the second conductive connecting sheet is connected to the surface of the first bare die away from the first conductive frame, and extends to be lapped on the third conductive frame, and the second conductive connecting sheet is disposed at an interval from the first conductive connecting sheet.

In an implementation of this application, both a fifth electrode of the first bare die and a sixth electrode of the second bare die are electrically connected to the second conductive connecting sheet, to implement an electrical connection between the fifth electrode and the sixth electrode.

The vertically laminated first bare die and second bare die packaged inside one device have three pairs of electrodes that are electrically interconnected.

In an implementation of this application, the first electrode is a first source, the third electrode is a first drain, the fifth electrode is a first gate, the second electrode is a second source, the fourth electrode is a second drain, and the sixth electrode is a second gate; the first source, the first drain, and the first gate are electrically connected in a one-to-one correspondence to the first conductive frame, the first conductive connecting sheet, and the second conductive connecting sheet; and the second source, the second drain, and the second gate are electrically connected in a one-to-one correspondence to the conductive cover plate, the first conductive connecting sheet, and the second conductive connecting sheet.

In an implementation of this application, the first source is connected in parallel to the second source, the first drain is connected in parallel to the second drain, and the first gate is connected in parallel to the second gate.

The first bare die and the second bare die may be MOSFET chips, and three terminals, namely, the sources, the drains, and the gates, of the second bare die and the first bare die that are vertically laminated inside the single device are connected in parallel, to greatly improve device performance.

In an implementation of this application, the first drain is electrically connected to the first conductive frame, the first gate is electrically connected to the first conductive connecting sheet, and the first source is electrically connected to the second conductive connecting sheet; and the second drain is electrically connected to the conductive cover plate, the second gate is electrically connected to the first conductive connecting sheet, and the second source is electrically connected to the second conductive connecting sheet.

In an implementation of this application, the conductive cover plate includes a flat plate and at least one side plate that is bent and connected to the flat plate, the flat plate covers the surface of the second bare die away from the first conductive frame, and each side plate is connected between the flat plate and the first conductive frame.

The side plates are supported between the flat plate and the first conductive frame to provide support. The conductive cover plate is connected to the first conductive frame by the bent side plate, and can bear a weight of the conductive cover plate itself and a weight of a plastic package material obtained after a part of the chip package module is packaged in plastic, to relieve stress of the first bare die below to some extent.

In an implementation of this application, each side plate is vertically connected to the flat plate.

In an implementation of this application, the conductive cover plate includes three side plates vertically connected to the flat plate.

The conductive cover plate is connected to the first conductive frame by three vertically bent side plates, and the three side plates can bear a weight of the conductive cover plate itself and a weight of a plastic package material obtained after a part of the chip package module is packaged in plastic, to relieve stress of the first bare die below to some extent.

In an implementation of this application, solder is disposed between the first bare die and the first conductive frame, and an electrical connection is implemented by soldering; solder is disposed in regions in which the first conductive connecting sheet is lapped on the first bare die and the second conductive frame, and the first conductive connecting sheet is electrically connected to the first bare die and the second conductive frame by soldering; solder is disposed in a region in which the second bare die is lapped on the first conductive connecting sheet, and the second bare die is electrically connected to the first conductive connecting sheet by soldering; and solder is disposed between the conductive cover plate and the second bare die, and the conductive cover plate is electrically connected to the second bare die by soldering.

A second aspect of embodiments of this application provides a power module, including a circuit board and a chip package module located on the circuit board. The chip package module is the chip package module according to the first aspect of embodiments of this application.

A third aspect of embodiments of this application provides an electronic device, including a circuit board and a chip package module located on the circuit board. The chip package module is the chip package module according to the first aspect of embodiments of this application.

A fourth aspect of embodiments of this application provides a method for manufacturing a chip package module, including:
providing a first conductive frame and a second conductive frame, where the second conductive frame is disposed at an interval beside the first conductive frame;
attaching a first bare die to the first conductive frame;
arranging a first conductive connecting sheet, where the first conductive connecting sheet is connected to a surface of the first bare die away from the first conductive frame, and extends to be lapped on the second conductive frame;
attaching a second bare die to the surface of the first bare die away from the first conductive frame, where the second bare die is connected to the first conductive connecting sheet; and
arranging a conductive cover plate, where the conductive cover plate is connected to a surface of the second bare die away from the first conductive frame, and extends to be connected to the first conductive frame.

According to the method for manufacturing a chip package module in this application, without challenging a device manufacturing process, performance of a single device is improved and a power density is increased through innovation of a package structure, so that a requirement of a high-performance power supply system for a device is met to some extent, and a stress condition of the device can be optimized through a special design of a conductive cover plate.

In an implementation of this application, the manufacturing method further includes: before the second bare die is arranged, providing a third conductive frame located at an interval beside the first conductive frame; and arranging a second conductive connecting sheet, where the second conductive connecting sheet is connected to the surface of the first bare die away from the first conductive frame and extends to be lapped on the third conductive frame, and the second conductive connecting sheet is disposed at an interval from the first conductive connecting sheet.

In an implementation of this application, the conductive cover plate includes a flat plate and at least one side plate that is bent and connected to the flat plate, the flat plate covers the surface of the second bare die away from the first conductive frame, and each side plate is connected between the flat plate and the first conductive frame.

In an implementation of this application, each of the first bare die and the second bare die includes a plurality of electrodes, the plurality of electrodes of the first bare die include a source, a drain, and a gate, and the plurality of electrodes of the second bare die also include a source, a drain, and a gate; the source, the drain, and the gate of the first bare die are electrically connected in a one-to-one correspondence to the first conductive frame, the first conductive connecting sheet, and the second conductive connecting sheet; the source, the drain, and the gate of the second bare die are electrically connected in a one-to-one correspondence to the conductive cover plate, the first conductive connecting sheet, and the second conductive connecting sheet; and the source of the first bare die is connected in parallel to the source of the second bare die, the drain of the first bare die is connected in parallel to the drain of the second bare die, and the gate of the first bare die is connected in parallel to the gate of the second bare die.

In an implementation of this application, the attaching a first bare die to the first conductive frame includes: arranging solder on the first conductive frame, placing the first bare die on the solder, and then electrically connecting the first bare die to the first conductive frame by soldering;
the arranging a first conductive connecting sheet and arranging a second conductive connecting sheet includes: arranging two groups of solder disposed at intervals on the surface of the first bare die away from the first conductive frame, arranging solder separately on the second conductive frame and the third conductive frame, then placing the first conductive connecting sheet on one group of solder of the first bare die and the solder on the second conductive frame, arranging the second conductive connecting sheet on the other group of solder of the first bare die and the solder on the third conductive frame, and electrically connecting the first conductive connecting sheet to the first bare die and the second conductive frame by soldering and electrically connecting the second conductive connecting sheet to the first bare die and the third conductive frame by soldering;
the attaching a second bare die includes: separately arranging solder on surfaces of the first conductive connecting sheet and the second conductive connecting sheet away from the first bare die, placing the second bare die on the solder, and electrically connecting the second bare die to the first conductive connecting sheet and the second conductive connecting sheet by soldering; and
the arranging a conductive cover plate includes: arranging solder on the surface of the second bare die away from the first conductive frame, placing the flat plate of the conductive cover plate on the solder, and electrically connecting the conductive cover plate to the second bare die by soldering.

### BRIEF DESCRIPTION OF DRAWINGS

FIG. 1 is a schematic diagram of a structure of a chip package module according to a first embodiment of this application;
FIG. 2 is a schematic top view of a chip package module according to an embodiment of this application;
FIG. 3 is a schematic cross-sectional view of the chip package module in FIG. 2 cut along a cross-sectional line III-III;
FIG. 4 is a schematic diagram of a structure of a chip package module according to a second embodiment of this application;
FIG. 5 to FIG. 13 are schematic diagrams of a process of manufacturing a chip package module according to an embodiment of this application;
FIG. 14 is a schematic diagram of a power module according to an embodiment of this application; and
FIG. 15 is a schematic diagram of an electronic device according to an embodiment of this application.

### DESCRIPTION OF EMBODIMENTS

The following describes embodiments of this application with reference to the accompanying drawings in embodiments of this application. Unless otherwise specified, a data range in this application should include endpoint values.

Embodiments of this application provide a chip package module with a novel structure. To resolve a problem that single-transistor performance cannot meet a system-level requirement due to slow wafer-level performance improvement, two bare wafers may be packaged in parallel in a single device, to reduce a single-transistor loss, improve a power density, and improve performance of a single-chip package module.

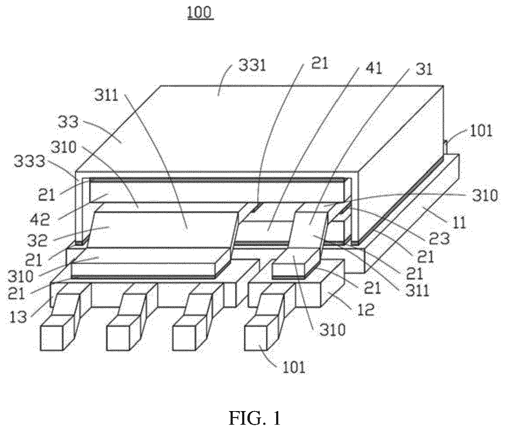

Referring to FIG. 1, FIG. 2, and FIG. 3, a chip package module 100 in a first embodiment of this application includes a first conductive frame 11, a second conductive frame 12, and a third conductive frame 13. The first conductive frame 11, the second conductive frame 12, and the third conductive frame 13 are disposed at an interval from each other. The first conductive frame 11, the second conductive frame 12, and the third conductive frame 13 all have a flat plate form. Each of the first conductive frame 11, the second conductive frame 12, and the third conductive frame 13 is connected to a pin 101. The pin 101 is configured to electrically connect to another electronic component (for example, an external circuit). Materials of the first conductive frame 11, the second conductive frame 12, and the third conductive frame 13 may be conductive metal.

As shown in FIG. 1, the chip package module 100 further includes a first bare die 41, a second bare die 42, a first conductive connecting sheet 31, and a second conductive connecting sheet 32. The first bare die 41 is disposed on the first conductive frame 11. In this embodiment, an area of a top surface that is of the first conductive frame 11 and that is used to place the first bare die 41 is larger than an area of the first bare die 41, and the first bare die 41 partially covers a top surface of the first conductive frame 11. Solder 21 is disposed between the first bare die 41 and the first conductive frame 11, and an electrical connection is implemented by soldering.

As shown in FIG. 1, the first conductive connecting sheet 31 partially covers and is connected to a surface of the first bare die 41 away from the first conductive frame 11, and extends to be lapped on the second conductive frame 12. The second conductive connecting sheet 32 partially covers and is connected to the surface of the first bare die 41 away from the first conductive frame 11, and extends to be lapped on the third conductive frame 13. The second conductive connecting sheet 32 and the first conductive connecting sheet 31 are disposed at an interval. Solder 21 is disposed in regions in which the first conductive connecting sheet 31 is lapped on the first bare die 41 and the second conductive frame 12, and the first conductive connecting sheet 31 is electrically connected to both the first bare die 41 and the second conductive frame 12 by soldering. Solder 21 is disposed in regions in which the second conductive connecting sheet 32 is lapped on the first bare die 41 and the third conductive frame 13, and the second conductive connecting sheet 32 is electrically connected to both the first bare die 41 and the third conductive frame 13 by soldering.

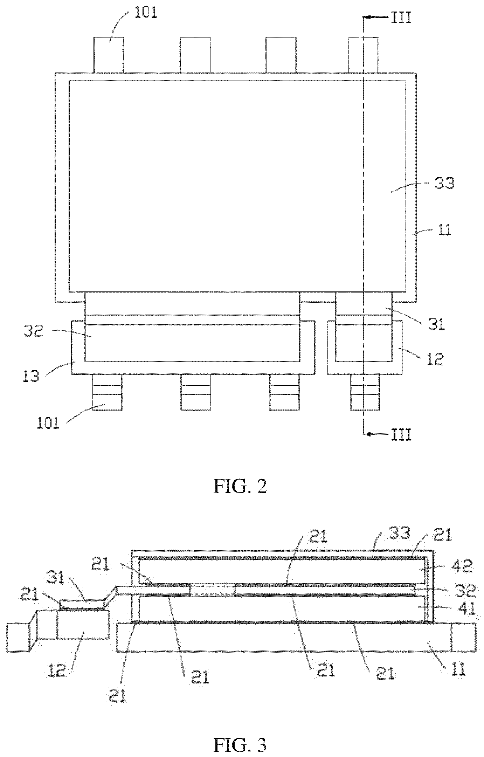

As shown in FIG. 1 and FIG. 3, the second bare die 42 is laminated on a surface of the first bare die 41 with the first conductive connecting sheet 31 and the second conductive connecting sheet 32, and is electrically connected to both the first conductive connecting sheet 31 and the second conductive connecting sheet 32. The first conductive connecting sheet 31 and the second conductive frame 12 are cooperatively disposed, and the second conductive connecting sheet 32 and the third conductive frame 13 are cooperatively disposed. Solder 21 is disposed in regions in which the second bare die 42 is lapped on the first conductive connecting sheet 31 and the second conductive connecting sheet 32, and the second bare die 42 is electrically connected to the first conductive connecting sheet 31 and the second conductive connecting sheet 32 by soldering. The first conductive connecting sheet 31 is electrically connected to the first bare die 41 and the second bare die 42. The second conductive connecting sheet 32 is also electrically connected to the first bare die 41 and the second bare die 42.

As shown in FIG. 1, the chip package module 100 further includes a conductive cover plate 33. The conductive cover plate 33 is connected to a surface of the second bare die 42 away from the first conductive frame 11, and extends to be connected to the first conductive frame 11. The conductive cover plate 33 includes a flat plate 331 and at least one side plate 333 that is bent and connected to the flat plate 331. The flat plate 331 covers the surface of the second bare die 42 away from the first conductive frame 11. Each side plate 333 is connected between the flat plate 331 and the first conductive frame 11. The conductive cover plate 33 and the first conductive frame 11 are cooperatively disposed. Solder 21 is disposed between the flat plate 331 and the second bare die 42, and solder 21 is also disposed between the side plate 333 and the first conductive frame 11. The conductive cover plate 33 is electrically connected to the second bare die 42 and the first conductive frame 11 by soldering.

In this embodiment, as shown in FIG. 1, the conductive cover plate 33 includes three side plates 333 vertically connected to the flat plate 331. On a side of the first conductive frame 11 on which the second conductive frame 12 and the third conductive frame 13 are disposed, the side plate 333 is not disposed, to keep the side plate 333 from affecting that the first conductive connecting sheet 31 and the second conductive connecting sheet 32 respectively extend to be lapped on the second conductive frame 12 and the third conductive frame 13. The side plates 333 are equivalently supported between the flat plate 331 and the first conductive frame 11, to provide a support force. A structure of the side plate 333 includes but is not limited to a right-angle bending (the side plate 333 is vertically connected to the flat plate 331), a step-shaped bending, a support column, and the like.

The conductive cover plate 33 is connected to the first conductive frame 11 by the three bent side plates 333. The three side plates 333 can bear a weight of the conductive cover plate 33 itself and a weight of a plastic package material obtained after a part of the chip package module 100 is packaged in plastic, to relieve stress of the first bare die 41 below to some extent.

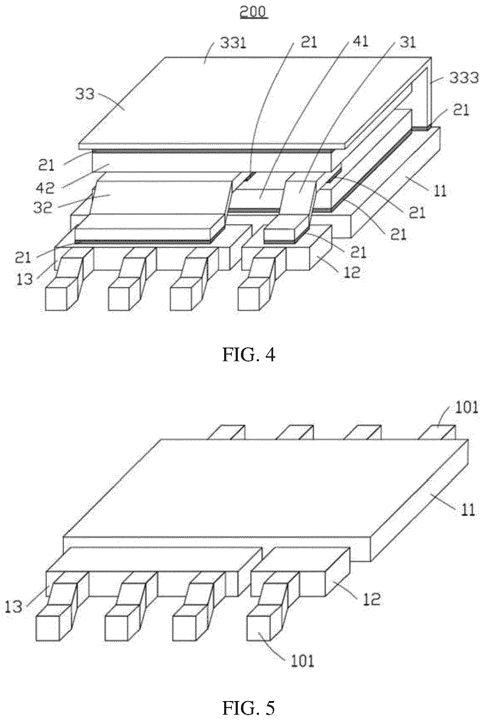

Referring to FIG. 4, a structure of a chip package module 200 in a second embodiment of this application is basically the same as a structure of the chip package module 100. A difference lies in that a conductive cover plate 33 of the chip package module 200 includes only one side plate 333 vertically connected to the flat plate 331. If a side of the first conductive frame 11 on which the second conductive frame 12 and the third conductive frame 13 are disposed is a first side, the unique side plate 333 is disposed on a second side opposite to the first side. The single side plate 333 is connected to the first conductive frame 11, which can also play a supporting role and reduce design and manufacturing difficulty of the conductive cover plate 33.

As shown in FIG. 1 to FIG. 3, the first conductive frame 11, the second conductive frame 12, and the third conductive frame 13 are all rectangular plates, and a size of the first conductive frame 11 is larger than a size of the second conductive frame 12 and a size of the third conductive frame 13. The second conductive frame 12 and the third conductive frame 13 are located on a same side edge of the first conductive frame 11. In this embodiment, a pin 101 of the first conductive frame 11 is connected to a side of the first conductive frame 11 away from the second conductive frame 12. A pin 101 of the second conductive frame 12 is connected to a side of the second conductive frame 12 away from the first conductive frame 11. A pin 101 of the third conductive frame 13 is connected to a side of the third conductive frame 13 away from the first conductive frame 11.

In this embodiment, the first conductive frame 11, the second conductive frame 12, and the third conductive frame 13 have a same thickness. Therefore, when the first bare die 41 is disposed on the first conductive frame 11, a height of the first bare die 41 is larger than that of the second conductive frame 12 and the third conductive frame 13. The first conductive connecting sheet 31 is bent and extends from the first bare die 41 to the second conductive frame 12 to be lapped on and cover the second conductive frame 12. The second conductive connecting sheet 32 is bent and extends from the first bare die 41 to the third conductive frame 13 to be lapped on and cover the third conductive frame 13. The first conductive connecting sheet 31 and the second conductive connecting sheet 32 are spaced from each other. As shown in FIG. 1, the first conductive connecting sheet 31 includes two flat parts 310 and a connecting part 311 connected between the two flat parts 310. One flat part 310 covers the first bare die 41, and the other flat part 310 covers the second conductive frame 12. The connecting part is bent and extends from an end part of each flat part 310. Similarly, the second conductive connecting part also includes two flat parts 310 and a connecting part 311 connected between the two flat parts 310. One flat part 310 covers the first bare die 41, and the other flat part 310 covers the third conductive frame 13. The connecting part 311 is bent and extends from an end part of each flat part 310.

The chip package module 100 may further include a plastic package layer (not shown in the figure) for packaging the conductive cover plate 33, the first bare die 41, and the second bare die 42. The conductive cover plate 33 may be included inside a plastic package body, or may be partially exposed to air to increase a heat dissipation capability.

The first conductive connecting sheet 31, the second conductive connecting sheet 32, and the conductive cover plate 33 may be made of a same material. The material is a metal material or a solid-state conductive organic material, but is not limited thereto.

Each of the first bare die 41 and the second bare die 42 includes a plurality of electrodes (not shown in the figure). An electrode (a first electrode) of the first bare die 41 is electrically connected to the first conductive frame 11. An electrode (a second electrode) of the second bare die 42 is electrically connected to the conductive cover plate 33. The first conductive frame 11 is electrically connected to the first bare die 41. Therefore, the first pair of electrodes of the first bare die 41 and the second bare die 42 are electrically connected to the conductive cover plate 33 by the first conductive frame 11. In addition, signal transmission with an external circuit is implemented through the first conductive frame 11. Another electrode (a third electrode) of the first bare die 41 and another electrode (a fourth electrode) of the second bare die 42 are both electrically connected to the first conductive connecting sheet 31. In other words, the second pair of electrodes of the first bare die 41 and the second bare die 42 are electrically connected by the first conductive connecting sheet 31, and then are electrically connected to the first conductive connecting sheet 31 by the second conductive frame 12 to implement signal transmission with an external circuit. Still another electrode (a fifth electrode) of the first bare die 41 and still another electrode (a sixth electrode) of the second bare die 42 are both electrically connected to the second conductive connecting sheet 32. That is, the third pair of electrodes of the first bare die 41 and the second bare die 42 are electrically connected by the second conductive connecting sheet 32, and then are electrically connected to the second conductive connecting sheet 32 by the third conductive frame 13, to implement signal transmission with an external circuit.

It may be understood that the first conductive connecting sheet 31 and the second conductive frame 12 are cooperatively disposed and the second conductive connecting sheet 32 and the third conductive frame 13 are cooperatively disposed according to a quantity of pairs of electrodes that need to be electrically connected in the first bare die 41 and the second bare die 42, and may be correspondingly increased or decreased as required. For example, if only one pair of electrodes in the first bare die 41 and the second bare die 42 need to be electrically connected, the first conductive connecting sheet 31 and the second conductive frame 12 and the second conductive connecting sheet 32 and the third conductive frame 13 may both be omitted. For example, if two pairs of electrodes in the first bare die 41 and the second bare die 42 need to be electrically connected, the second conductive connecting sheet 32 and the third conductive frame 13 may be omitted.

According to the chip package modules 100 and 200 in this application, the first conductive connecting sheet 31, the second conductive connecting sheet 32, and the conductive cover plate 33 are used to implement electrical interconnection between the bare dies 41 and 42 that are vertically laminated, and the two bare dies are packaged inside one device, so that performance of a single device is improved, and a requirement of a high-performance power supply system for a device is met to some extent.

In an embodiment, both the first bare die 41 and the second bare die 42 are MOSFET chips. The plurality of electrodes of the first bare die 41 include a source, a drain, and a gate, and the plurality of electrodes of the second bare die 42 also include a source, a drain, and a gate. The source, the drain, and the gate of the first bare die 41 are electrically connected in a one-to-one correspondence to the first conductive frame 11, the first conductive connecting sheet 31, and the second conductive connecting sheet 32. A specific correspondence connection relationship is not limited. For example, the source of the first bare die 41 is electrically connected to any one of the first conductive frame 11, the first conductive connecting sheet 31, and the second conductive connecting sheet 32. The drain of the first bare die 41 is electrically connected to one of the remaining two of the first conductive frame 11, the first conductive connecting sheet 31, and the second conductive connecting sheet 32. The gate of the first bare die 41 is electrically connected to the last remaining one of the first conductive frame 11, the first conductive connecting sheet 31, and the second conductive connecting sheet 32. The source, the drain, and the gate of the second bare die 42 are electrically connected in a one-to-one correspondence to the conductive cover plate 33, the first conductive connecting sheet 31, and the second conductive connecting sheet 32. A specific correspondence connection relationship is not limited. For example, the source of the second bare die 42 is electrically connected to any one of the conductive cover plate 33, the first conductive connecting sheet 31, and the second conductive connecting sheet 32. The drain of the second bare die 42 is electrically connected to one of the remaining two of the conductive cover plate 33, the first conductive connecting sheet 31, and the second conductive connecting sheet 32. The gate of the second bare die 42 is electrically connected to the last remaining one of the conductive cover plate 33, the first conductive connecting sheet 31, and the second conductive connecting sheet 32. The source of the first bare die 41 is connected in parallel to the source of the second bare die 42. The drain of the first bare die 41 is connected in parallel to the drain of the second bare die 42. The gate of the first bare die 41 is connected in parallel to the gate of the second bare die 42. The three terminals, namely, the sources, the drains, and the gates, of the second bare die 42 and the first bare die 41 that are vertically laminated are connected in parallel.

In this embodiment, the first electrode of the first bare die 41 is the drain and is electrically connected to the first conductive frame 11. The third electrode of the first bare die 41 is the gate and is electrically connected to the first conductive connecting sheet 31. The fifth electrode of the first bare die 41 is the source and is electrically connected to the second conductive connecting sheet 32. However, this is not limited thereto. The second electrode of the second bare die 42 is the drain and is electrically connected to the conductive cover plate 33. The fourth electrode of the second bare die 42 is the gate and is electrically connected to the first conductive connecting sheet 31. The sixth electrode of the second bare die 42 is the source and is electrically connected to the second conductive connecting sheet 32. However, this is not limited thereto. In this case, the three terminals, namely, the sources, the drains, and the gates, of the second bare die 42 and the first bare die 41 are connected in parallel.

According to the chip package modules 100 and 200 in this application, the first conductive connecting sheet 31, the second conductive connecting sheet 32, and the conductive cover plate 33 are used to implement a parallel connection of the three terminals of the bare dies 41 and 42 that are vertically laminated, so that a single device has vertically laminated chips, and performance of the device is greatly improved.

It may be understood that sizes and thicknesses of the first bare die 41 and the second bare die 42, and an area of the solder 21 to be coated in the chip package module 100 may be adjusted and designed as required.

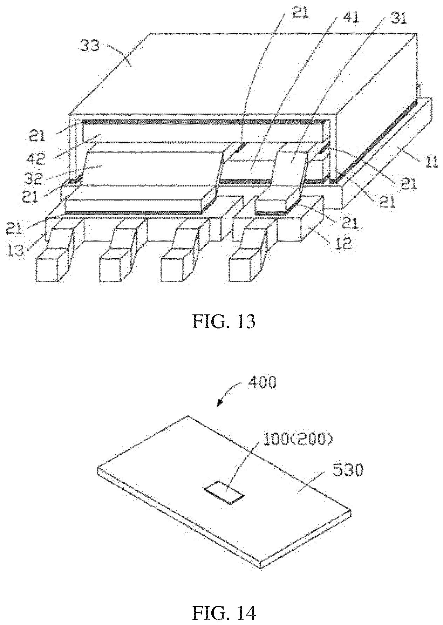

As shown in FIG. 14, this application further provides a power module 400, including a circuit board 530 and the foregoing chip package modules 100 and 200 located on the circuit board 530. The pins 101 of the first conductive frame 11, the second conductive frame 12, and the third conductive frame 13 may all be electrically connected to the circuit board 530.

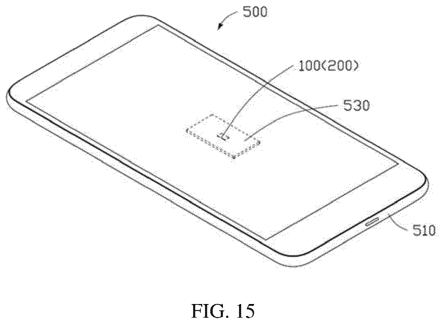

As shown in FIG. 15, this application further provides an electronic device 500, including a housing 510, a circuit board 530 located in the housing 510, and the foregoing chip package modules 100 and 200 located on the circuit board 530.

Referring to FIG. 5 to FIG. 13, this application further provides a method for manufacturing the foregoing chip package module, including the following steps.
(1) Provide a first conductive frame 11, a second conductive frame 12, and a third conductive frame 13. The first conductive frame 11, the second conductive frame 12, and the third conductive frame 13 are disposed at an interval from each other.
(2) Attach a first bare die 41 to the first conductive frame 11.
(3) Arrange a first conductive connecting sheet 31 and a second conductive connecting sheet 32. The first conductive connecting sheet 31 covers a surface of the first bare die 41 away from the first conductive frame 11 and extends to be lapped on the second conductive frame 12. The second conductive connecting sheet 32 covers the surface of the first bare die 41 away from the first conductive frame 11 and extends to be lapped on the third conductive frame 13.
(4) Attach a second bare die 42 on a surface of the first bare die 41 with the first conductive connecting sheet 31 and the second conductive connecting sheet 32.
(5) Arrange a conductive cover plate 33. The conductive cover plate 33 includes a flat plate 331 and at least one side plate 333 that is bent and connected to the flat plate 331. The flat plate 331 covers a surface of the second bare die 42 away from the first conductive frame 11. Each side plate 333 is connected between the flat plate 331 and the first conductive frame 11.

It may be understood that, as described above, the first conductive connecting sheet 31 and the second conductive frame 12 are cooperatively disposed and the second conductive connecting sheet 32 and the third conductive frame 13 are cooperatively disposed according to a quantity of pairs of electrodes that need to be electrically connected in the first bare die 41 and the second bare die 42, and may be correspondingly increased or decreased as required.

In this embodiment, as shown in FIG. 5, the first conductive frame 11, the second conductive frame 12, and the third conductive frame 13 are all rectangular flat blocks, and a size of the first conductive frame 11 is larger than a size of the second conductive frame 12 and a size of the third conductive frame 13. The second conductive frame 12 and the third conductive frame 13 are located on a same side edge of the first conductive frame 11. The first conductive frame 11, the second conductive frame 12, and the third conductive frame 13 are all connected to pins 101. In this embodiment, the pin 101 of the first conductive frame 11 is connected to a side of the first conductive frame 11 away from the second conductive frame 12. The pin 101 of the second conductive frame is connected to a side of the second conductive frame 12 away from the first conductive frame 11. The pin 101 of the third conductive frame 13 is connected to a side of the third conductive frame 13 away from the first conductive frame 11. The first conductive frame 11, the second conductive frame 12, and the third conductive frame 13 may be obtained by cutting a conductive metal plate. The pins 101 may also be obtained by processing the conductive metal plate. To be specific, the conductive frames and the pins 101 connected to the conductive frames are integrally formed. However, this application is not limited thereto.

In this embodiment, the first conductive frame 11, the second conductive frame 12, and the third conductive frame 13 have a same thickness.

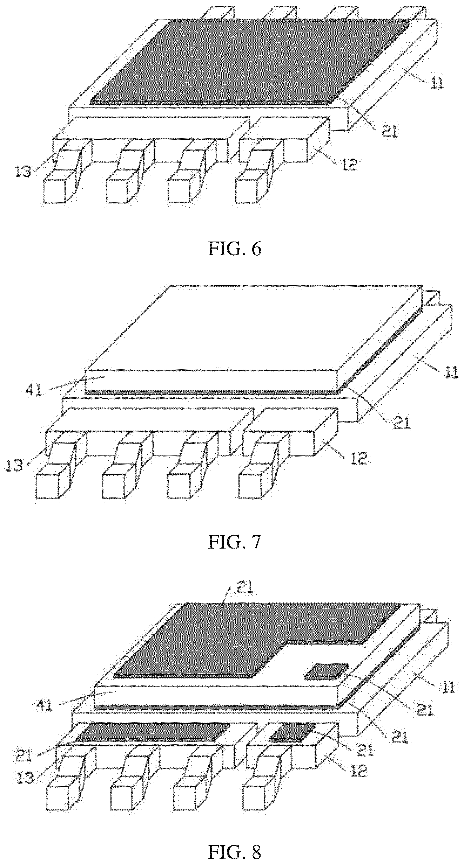

As shown in FIG. 6 and FIG. 7, that attaching a first bare die 41 to the first conductive frame 11 includes: arranging solder 21 on the first conductive frame 11, placing the first bare die 41 on the solder 21, and then electrically connecting the first bare die 41 to the first conductive frame 11 by soldering, for example, performing heating (a heating temperature generally does not exceed 450 degrees Celsius) to splice the solder 21 between the first bare die 41 and the first conductive frame 11.

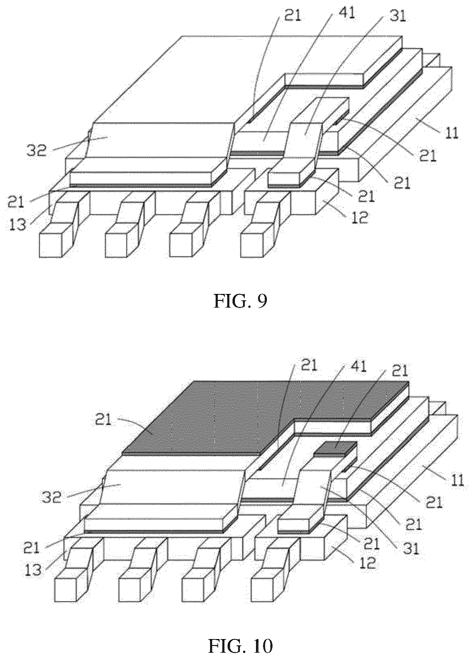

As shown in FIG. 8 and FIG. 9, the arranging a first conductive connecting sheet 31 and arranging a second conductive connecting sheet 32 includes: arranging two groups of solder 21 disposed at intervals on the surface of the first bare die 41 away from the first conductive frame 11, arranging solder 21 separately on the second conductive frame 12 and the third conductive frame 13, then placing the first conductive connecting sheet 31 on one group of solder 21 of the first bare die 41 and the solder 21 on the second conductive frame 12, arranging the second conductive connecting sheet 32 on the other group of solder 21 of the first bare die 41 and the solder 21 on the third conductive frame 13, and electrically connecting the first conductive connecting sheet 31 to the first bare die 41 and the second conductive frame 12 by soldering and electrically connecting the second conductive connecting sheet 32 to the first bare die 41 and the third conductive frame 13 by soldering, for example, performing heating (the heating temperature generally does not exceed 450 degrees Celsius) to splice the solder 21 between the first bare die 41 and the first conductive connecting sheet 31 and between the second conductive frame 12 and the first conductive connecting sheet 31, and performing heating to splice the solder 21 between the first bare die 41 and the second conductive connecting sheet 32 and between the third conductive frame 13 and the second conductive connecting sheet 32.

A shape of the first conductive connecting sheet 31 needs to match shapes of the first bare die 41 and the first conductive frame 11. The first conductive connecting sheet 31 includes two flat parts 310 and a connecting part 311 connected between the two flat parts 310. The connecting part 311 is bent and extends from an end part of each flat part 310. One flat part 310 covers the first bare die 41, and the other flat part 310 covers the second conductive frame 12. Similarly, a shape of the second conductive connecting part needs to match shapes of the first bare die 41 and the second conductive frame 12. The second conductive connecting part also includes two flat parts 310 and a connecting part 311 connected between the two flat parts 310. The connecting part 311 is bent and extends from an end part of each flat part 310. One flat part 310 covers the first bare die 41, and the other flat part 310 covers the third conductive frame 13.

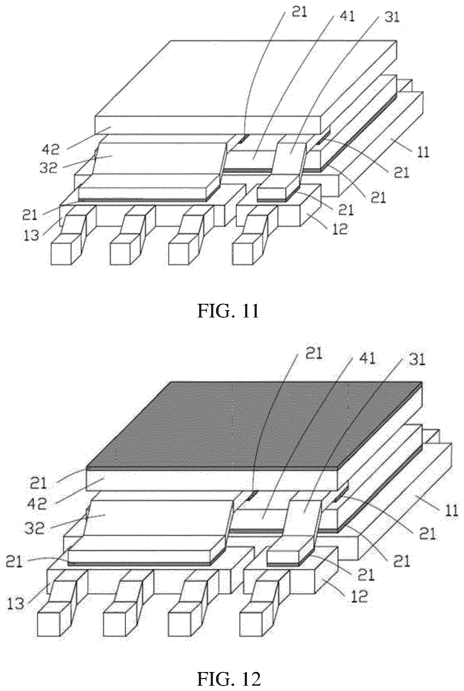

As shown in FIG. 10 and FIG. 11, the attaching a second bare die 42 includes: separately arranging solder 21 on surfaces of the first conductive connecting sheet 31 and the second conductive connecting sheet 32 away from the first bare die 41, placing the second bare die 42 on the solder 21, and electrically connecting the second bare die 42 to the first conductive connecting sheet 31 and the second conductive connecting sheet 32 by soldering, for example, performing heating to splice the solder 21 between the second bare die 42 and the first conductive connecting sheet 31 and between the second bare die 42 and the second conductive connecting sheet 32.

As shown in FIG. 12 and FIG. 13, the arranging a conductive cover plate 33 includes: arranging solder 21 on the surface of the second bare die 42 away from the first conductive frame 11, placing the flat plate 331 of the conductive cover plate 33 on the solder 21, and electrically connecting the conductive cover plate 33 to the second bare die 42 by soldering, for example, performing heating to splice the solder 21 between the conductive cover plate 33 and the second bare die 42.

According to the method for manufacturing a chip package module in this application, without challenging a device manufacturing process, performance of a single device is improved and a power density is increased through innovation of a package structure, so that a requirement of a high-performance power supply system for a device is met to some extent, and a stress condition of the device can be optimized through a special design of a conductive cover plate.

It should be noted that the foregoing descriptions are merely specific implementations of this application, but are not intended to limit the protection scope of this application. Any variation or replacement that may be readily figured out by a person skilled in the art within the technical scope disclosed in this application shall fall within the protection scope of this application. The implementations in this application and the features in the implementations may be combined with each other without causing any conflict. Therefore, the protection scope of this application shall be subject to the protection scope of the claims.

## Claims

1. A chip package module, comprising:
a first conductive frame;
a first bare die, disposed on the first conductive frame;
a second conductive frame, disposed at an interval from the first conductive frame;
a first conductive connecting sheet, connected to a surface of the first bare die away from the first conductive frame, and extending to be lapped on the second conductive frame;
a second bare die, laminated on the surface of the first bare die away from the first conductive frame, and connected to the first conductive connecting sheet; and
a conductive cover plate, connected to a surface of the second bare die away from the first conductive frame, and extending to be connected to the first conductive frame.

2. The chip package module according to claim 1, wherein
a first electrode of the first bare die is electrically connected to the first conductive frame, and a second electrode of the second bare die is electrically connected to the conductive cover plate, to implement an electrical connection between the first electrode and the second electrode; and
both a third electrode of the first bare die and a fourth electrode of the second bare die are electrically connected to the first conductive connecting sheet, to implement an electrical connection between the third electrode and the fourth electrode.

3. The chip package module according to claim 1 or 2, wherein the chip package module further comprises a third conductive frame and a second conductive connecting sheet, and the first conductive frame, the second conductive frame, and the third conductive frame are disposed at an interval from each other; and the second conductive connecting sheet is connected to the surface of the first bare die away from the first conductive frame, and extends to be lapped on the third conductive frame, and the second conductive connecting sheet is disposed at an interval from the first conductive connecting sheet.

4. The chip package module according to claim 3, wherein both a fifth electrode of the first bare die and a sixth electrode of the second bare die are electrically connected to the second conductive connecting sheet, to implement an electrical connection between the fifth electrode and the sixth electrode.

5. The chip package module according to claim 4, wherein the first electrode is a first source, the third electrode is a first drain, the fifth electrode is a first gate, the second electrode is a second source, the fourth electrode is a second drain, and the sixth electrode is a second gate; the first source, the first drain, and the first gate are electrically connected in a one-to-one correspondence to the first conductive frame, the first conductive connecting sheet, and the second conductive connecting sheet; and the second source, the second drain, and the second gate are electrically connected in a one-to-one correspondence to the conductive cover plate, the first conductive connecting sheet, and the second conductive connecting sheet.

6. The chip package module according to claim 5, wherein the first source is connected in parallel to the second source, the first drain is connected in parallel to the second drain, and the first gate is connected in parallel to the second gate.

7. The chip package module according to claim 6, wherein the first drain is electrically connected to the first conductive frame, the first gate is electrically connected to the first conductive connecting sheet, and the first source is electrically connected to the second conductive connecting sheet; and the second drain is electrically connected to the conductive cover plate, the second gate is electrically connected to the first conductive connecting sheet, and the second source is electrically connected to the second conductive connecting sheet.

8. The chip package module according to any one of claims 1 to 7, wherein the conductive cover plate comprises a flat plate and at least one side plate that is bent and connected to the flat plate, the flat plate covers the surface of the second bare die away from the first conductive frame, and each side plate is connected between the flat plate and the first conductive frame.

9. The chip package module according to claim 8, wherein each side plate is vertically connected to the flat plate.

10. The chip package module according to claim 8 or 9, wherein the conductive cover plate comprises three side plates vertically connected to the flat plate.

11. The chip package module according to claim 8 or 9, wherein solder is disposed between the first bare die and the first conductive frame, and an electrical connection is implemented by soldering; solder is disposed in regions in which the first conductive connecting sheet is lapped on the first bare die and the second conductive frame, and the first conductive connecting sheet is electrically connected to the first bare die and the second conductive frame by soldering; solder is disposed in a region in which the second bare die is lapped on the first conductive connecting sheet, and the second bare die is electrically connected to the first conductive connecting sheet by soldering; and solder is disposed between the conductive cover plate and the second bare die, and the conductive cover plate is electrically connected to the second bare die by soldering.

12. A power module, comprising a circuit board and a chip package module located on the circuit board, wherein the chip package module is the chip package module according to any one of claims 1 to 11.

13. An electronic device, comprising a circuit board and a chip package module located on the circuit board, wherein the chip package module is the chip package module according to any one of claims 1 to 11.

14. A method for manufacturing a chip package module, comprising:
providing a first conductive frame and a second conductive frame, wherein the second conductive frame is disposed at an interval beside the first conductive frame;
attaching a first bare die to the first conductive frame;
arranging a first conductive connecting sheet, wherein the first conductive connecting sheet is connected to a surface of the first bare die away from the first conductive frame, and extends to be lapped on the second conductive frame;
attaching a second bare die to the surface of the first bare die away from the first conductive frame, wherein the second bare die is connected to the first conductive connecting sheet; and
arranging a conductive cover plate, wherein the conductive cover plate is connected to a surface of the second bare die away from the first conductive frame, and extends to be connected to the first conductive frame.

15. The method for manufacturing a chip package module according to claim 14, wherein the manufacturing method further comprises: before the second bare die is arranged, providing a third conductive frame located at an interval beside the first conductive frame; and arranging a second conductive connecting sheet, wherein the second conductive connecting sheet is connected to the surface of the first bare die away from the first conductive frame and extends to be lapped on the third conductive frame, and the second conductive connecting sheet is disposed at an interval from the first conductive connecting sheet.

16. The method for manufacturing a chip package module according to claim 14 or 15, wherein the conductive cover plate comprises a flat plate and at least one side plate that is bent and connected to the flat plate, the flat plate covers the surface of the second bare die away from the first conductive frame, and each side plate is connected between the flat plate and the first conductive frame.

17. The method for manufacturing a chip package module according to claim 15, wherein each of the first bare die and the second bare die comprises a plurality of electrodes, the plurality of electrodes of the first bare die comprise a source, a drain, and a gate, and the plurality of electrodes of the second bare die also comprise a source, a drain, and a gate; the source, the drain, and the gate of the first bare die are electrically connected in a one-to-one correspondence to the first conductive frame, the first conductive connecting sheet, and the second conductive connecting sheet; the source, the drain, and the gate of the second bare die are electrically connected in a one-to-one correspondence to the conductive cover plate, the first conductive connecting sheet, and the second conductive connecting sheet; and the source of the first bare die is connected in parallel to the source of the second bare die, the drain of the first bare die is connected in parallel to the drain of the second bare die, and the gate of the first bare die is connected in parallel to the gate of the second bare die.

18. The method for manufacturing a chip package module according to claim 15, wherein the attaching a first bare die to the first conductive frame comprises: arranging solder on the first conductive frame, placing the first bare die on the solder, and then electrically connecting the first bare die to the first conductive frame by soldering;
the arranging a first conductive connecting sheet and arranging a second conductive connecting sheet comprises: arranging two groups of solder disposed at intervals on the surface of the first bare die away from the first conductive frame, arranging solder separately on the second conductive frame and the third conductive frame, then placing the first conductive connecting sheet on one group of solder of the first bare die and the solder on the second conductive frame, arranging the second conductive connecting sheet on the other group of solder of the first bare die and the solder on the third conductive frame, and electrically connecting the first conductive connecting sheet to the first bare die and the second conductive frame by soldering and electrically connecting the second conductive connecting sheet to the first bare die and the third conductive frame by soldering;
the attaching a second bare die comprises: separately arranging solder on surfaces of the first conductive connecting sheet and the second conductive connecting sheet away from the first bare die, placing the second bare die on the solder, and electrically connecting the second bare die to the first conductive connecting sheet and the second conductive connecting sheet by soldering; and
the arranging a conductive cover plate comprises: arranging solder on the surface of the second bare die away from the first conductive frame, placing the flat plate of the conductive cover plate on the solder, and electrically connecting the conductive cover plate to the second bare die by soldering.
